# EUROPÄISCHE PATENTSCHRIFT

(11) **EP 0 533 964 B1**
(45) Veröffentlichungstag und Bekanntmachung des Hinweises auf die Patenterteilung: **25.10.1995**
(21) Anmeldenummer: 91114540.7
(22) Anmeldetag: 29.08.1991
(51) Int. Cl.: G01R 21/127

(54) **Anordnung zum Bilden von Produktsignalen**
Device for forming a product of signals
Dispositif pour la multiplication de signaux

(43) Veröffentlichungstag der Anmeldung: 31.03.1993
(73) Patentinhaber: DEUTSCHE ZAEHLER-GESELLSCHAFT Nachf. A. Stepper & Co. (GmbH & Co.), 22083 Hamburg (DE)
(72) Erfinder: Herrmann, Frank, Dipl.-Ing., W-3300 Braunschweig (DE); Stojanovic, Boris, YU-11000 Belgrad (YU)
(74) Vertreter: Richter, Werdermann & Gerbaulet

(56) Entgegenhaltungen:
- GB-A- 2 205 425
- US-A- 3 975 682
- US-A- 4 786 861
- US-A- 4 794 333
- IEEE TRANSACTIONS ON INSTRUMENTATION AND MEASUREMENT Bd. 39, Nr. 1, Februar
- 1990, NEW YORK, US Seiten 15 - 18; PIOTR S. FILIPSKI: 'A TDM Wattmeter with 0. 5-MHz Carrier Frequency'
- Siliconix Datenbuch 1976, Seite 7-82, linke Spalte, 1. Absatz; Seite 7-100, linke Spalte, 1. Absatz; Seiten 8-1 und 8-5
- Linear Technology 1990 Databook, Seite 11-20, linke Spalte, 2. Absatz

## Beschreibung

Die Erfindung geht aus von einer Anordnung zum Bilden von Produktsignalen, bei der eine erste Eingangsgröße über einen ersten, mit einer ersten Taktfrequenz arbeitenden Impuls-Weiten-Modulator einen (ersten) Schalter betätigt, über den eine zweite Eingangsgröße einem zu einem Quantisierer gehörenden Integrator zugeführt wird, wobei an Ausgang des Quantisierers Impulse mit einer dem Produkt entsprechenden Frequenz auftreten.

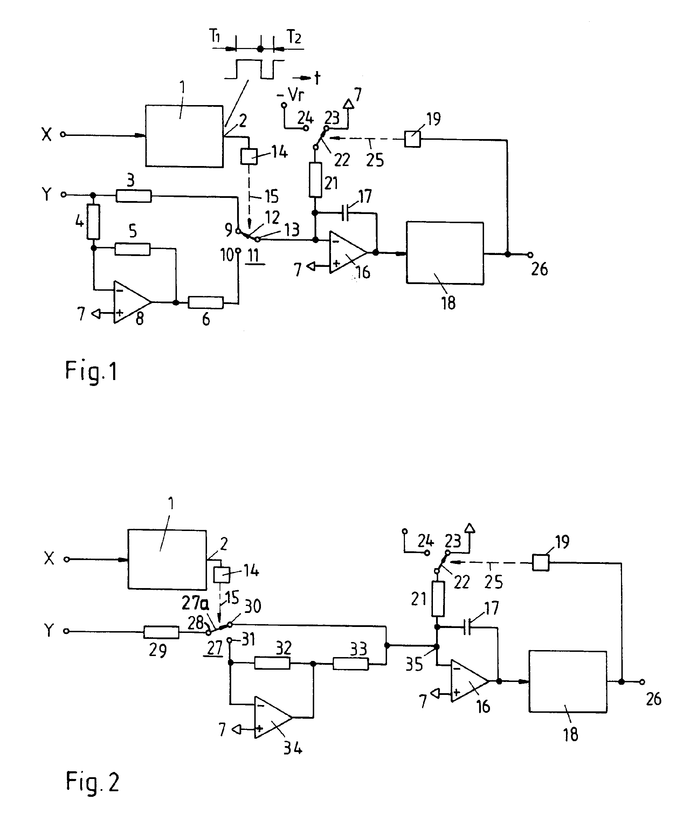

Prinzipielle Anordnungen eines konventionellen Meßsystems dieser Art sind in den Figuren 1 und 2 dargestelt.

Die Eingangsgröße X, z.B. der Strom zu einem Energie-Abnehmer aus einem öffentlichen Versorgungsnetz, wird einem Impuls-Weiten-Modulator 1 zugeführt, der an seinem Ausgang Impulse mit einer Breite T1 liefert, die durch Pausen mit der Länge T2 unterbrochen sind. Die Periode (T1 + T2) entspricht einer mittleren Frequenz von z.B. 2000 Hz, die somit etwa vierzigmal so groß ist wie die Frequenz der ersten Eingangsgröße X in einem Versorgungsnetz mit 50 Hz. Die Impuls-Weiten-Modulation führt am Ausgang 2 zu einer Modulationsgröße (T1 - T2)/(T1 + T2), die so mit positiven und negativen Werten die erste Eingangsgröße X abbildet, und die somit, wenn die Eingangsgröße X Null ist, ebenfalls den Null-wert annimmt.

Die Eingangsgröße Y wird über eine an sich bekannte Anordnung mit den Widerständen 3,4,5 und 6 und einem an eine positive Speisequelle 7 angeschlossenen Verstärker 8 in zwei gleiche Signale entgegengesetzter Polarität umgewandelt, die den Eingangskontakten 9 und 10 eines Umschalters 11 zugeführt werden, dessen Schaltverbindung 12 entweder den Eingangskontakt 9 oder den Eingangskontakt 10 an den Ausgangskontakt 13 anschließt.

Das Signal vom Ausgang 2 des Impuls-Weiten-Modulators 1 wird einer Antriebsvorrichtung 14 zugeführt, die die Schaltverbindung gemäß der gestrichelten Linie 15 zwischen den Kontakten 9 und 11 bzw. 10 und 11 hin- und herschaltet. So wird die Eingangsgröße Y mit ihrer Amplitude, aber entsprechend der Impuls-Weiten-Modulation wechselnder Polarität einem Integrator zugeführt, der durch einen Verstärker 16 und einen zwischen Ausgang und Eingang angeschlossenen Kondensator 17 gebildet wird. Dem Integrator 16, 17 ist ein monostabiles Kippglied 18 nachgeschaltet, das dann, wenn das Ausgangssignal des Verstärkers 16 einen Schwellwert überschreitet, einen einzelnen Impuls an eine zweite Antriebsvorrichtung 19 abgibt.

Der Eingang des Verstärkers 16 ist weiter über einen Widerstand 21 mit der Schaltverbindung 22 verbunden, die in der Ruhestellung über einen Eingangskontakt 23 mit dem positiven Pol 7 und in der Arbeitsstellung über einen Eingangskontakt 24 mit einer vorzugsweise negativen Referenzspannung Vr verbunden ist. Wenn der Impuls am Ausgang des Kippgliedes 18 auftritt, wird über die Antriebsvorrichtung 19 und die gestrichelt angedeutete Verbindung 25 die Schaltverbindung 22 vom Eingangskontakt 23 während der Dauer des Impulses auf den Eingangskontakt 24 umgeschaltet und dadurch der Eingang des Integrators 16,17 auf die Anfangsstellung zurückgesetzt.

Je nachdem, wie groß die Eingangsgröße 13 ist, wird am Kontakt die zweite Eingangsgröße Y kürzer oder länger mit der einen bzw. der anderen Polarität über den Umschalter 11 am Eingang des Integrators 16,17 wirksam gemacht und der Ausgangsimpuls des Kippgliedes öfter oder seltener an die Antriebsvorrichtung 19 abgegeben. Die Frequenz dieser Impulse ist somit ein Maß für die Größe des Produktes (X * Y) und kann vom Ausgang der Kippstufe 18 an der Klemme 26 abgenommen und z.B. zur Leistungs- oder Energiemessung einem Zählwerk zugeführt werden. Die dargestellte Anordnung mit dem Integrator 16,17, dem Kippglied 18, dem Widerstand 21 und dem von der Antriebsvorrichtung 19 betätigten Umschalter 22 wirkt somit als Quantisierer für das erwähnte Produkt.

In einer bekannten Anordnung nach Figur 1 treten durch den Schalter 11 störende Ladungs-Injektionseffekte auf. Ein solcher Schalter ist hochohmig, und die Kapazitäten an den Kontakten sind jeweils umzuladen, wobei unerwünschte Signalanteile wirksam werden. Diese Einflüsse sind wesentlich reduziert in einer abgewandelten Anordnung nach Figur 2, in der gleiche Teile mit gleichen Bezugszeichen versehen sind.

Das Ausgangssignal des Modulators 1 steuert hier einen dritten Umschalter 27, dessen Schaltverbindung 27a über den Eingangskontakt 28 über einen Vorwiderstand 29 die zweite Eingangsgröße Y zugeführt wird. Die erste Ausgangsklemme 30 des Umschalters 27 ist direkt und die zweite Ausgangsklemme 31 ist über einen aus zwei Widerständen 32 und 33 und einem Verstärker 34 bestehenden Inverter mit dem Eingang 35 des Quantisierers 16 bis 25 verbunden, der, wie in Figur 1, an der Ausgangsklemme 26 Impulse mit einer dem Produkt (X x Y) entsprechenden Frequenz liefert.

Ein Marginalproblem der Analog-Schalter stellt die Ladungs-Injektion während ihrer Ansteuerung dar. Sowohl Hersteller als auch Anwender suchen seit Jahren nach Lösungen, um die über die GATE-SOURCE-Kapazität von FET-Schaltern in den Signalweg eingekoppelten Störungen zu minimieren. Eine Lösung stellt die Verwendung von 2 Schaltern dar, wie sie in der einschlägigen Literatur der Schalterhersteller (vergl. Silikonix 1976 Datenbuch und Linear Technology 1989 Databook) oder in der Veröffentlichung von Filipski und von Stojanovic (DE 35 29 472 Al) verwendet wird. Wird dieses Prinzip auch hier verwandt, erreicht man, daß mit dem Inverter 32,33,34 in Figur 2 nicht, wie in Figur 1, die ungeschaltete Eingangsgröße Y, sondern das bereits geschaltete Signal invertiert wird und die Gesamtladung des Ladungs-Injektions-Effektes auf die Differenzladung während beider Schaltbewegungen reduziert werden kann. Die Störung wird dadurch um eine Zehner-Potenz vermindert (IEEE TRANSACTIONS ON INSTRUMENTATION AND MEASUREMENT, Bd. 39, Nr. 1, Feb. 1990, New York, US, S. 15-18).

In der Anordnung nach Figur 2 sind zwar die Ladungs-Injektions-Effekte am Umschalter 27 wesentlich vermindert. Es tritt aber noch immer der Nachteil auf, daß der beschriebene Quantisierer ein Spannungs-Frequenz-Umsetzer ist, der keine inverse Energierichtung mißt und der keine niedrigen, aber exakt gemessenen Ausgangsfrequenzen liefern kann.

Zum Stand der Technik kann noch die DE-A-35 29 472 und die EP-A-0 389 749 genannt werden.

Wenn bei der bekannten Schaltung nach Figur 1 oder Figur 2 die zu quantisierende Energie klein ist, muß lange Zeit gewartet werden, bis das Energiequant abgegeben wird. Die schlechteste Situation ergibt sich, wenn im Nullpunkt die Eingangsinformation überhaupt fehlt; die Justierung der Anordnung wird dadurch erschwert, daß keine Ausgangs-Impulsfolge zur Beurteilung herangezogen werden kann.

Der Erfindung liegt die Aufgabe zugrunde, diesen Nachteil zu vermeiden und die Anordnung so auszulegen, daß auch dann eine Ausgangspulsaktion entsteht, wenn das Produkt der Eingangsgrößen Null ist.

Diese Aufgabe wird bei einer Anordnung der eingangs erwähnten Art dadurch gelöst, daß gemäß der Erfindung der erste Integrator einen Teil eines zweiten, mit einer zweiten Taktfrequenz arbeitenden Impuls-Weiten-Modulators bildet, dessen Ausgangsimpulse einerseits einen zweiten Schalter betätigen, über den dem ersten Integrator abwechselnd ein erster und ein zweiter, vorzugsweise entgegengesetzt gleicher, Einstellstrom zugeführt wird, und andererseits ein mit einer dritten Taktfrequenz aufwärts bzw. abwärts zählendes Schieberegister steuern, das bei Erreichen eines Grenzwertes (Schwelle) die Impulse mit der dem Produkt entsprechenden Frequenz liefert, und daß der zweite Impuls-Weiten-Modulator einen zweiten Integrator umfaßt.

Dadurch, daß ein an sich bekannter Impuls-Weiten-Modulator im Quantisierer verwendet wird, konvertiert die Schaltung die Eingangsinformation nicht gleich in eine Impulsfolge mit informationsproportionaler Wiederholungsrate, sondern in einen Impulszug mit gesteuertem Impuls-Pausen-Verhältnis. Dieser Impulszug ist dann auch vorhanden, wenn das die Information bildende Produkt Null ist und somit Impuls und Pause gleichlang sind. Das Impuls-Pausen-Verhältnis kann in einfacher Weise durch Ausmessen von Impulslänge und Impulspause mittels des Schieberegisters bestimmt werden, wobei eine große Genauigkeit erzielt werden kann dadurch, daß das Schieberegister von einer Taktfrequenz gesteuert wird, die von einer Quarzzeitbasis abgeleitet ist. Eine solche Schaltung kann auch negative Produkte ausmessen, die durch eine entsprechende Umkehr des Verhältnisses von Impulszeit zu Pausenzeit dargestellt werden. Bei einem Elektrizitätszähler kann somit auch Energie gemessen werden, die vom Abnehmer in das Netz zurückgeliefert wird.

Der Ausgang des ersten Integrators kann an den Eingang eines Komparators des Zweiten Impuls-Weiten-Modulators angeschlossen werden, der die Ausgangsimpulse für den zweiten Schalter und für das Schieberegister liefert. Dem Integrator werden die in der Impuls-Weite und der Impuls-Amplitude vom Produkt (X * Y) modulierten Impulse zugeführt, die am Ausgang des Integrators zu einem dreieckförmigen Spannungsverlauf führen. Dieser Spannungsverlauf wird über den Komparator in einen in der Impuls-Weite modulierten Spannungszug übergeführt und dann vom Schieberegister ausgewertet.

Wenn der Ausgang des ersten Integrators an den Eingang eines mit einer dritten Taktfrequenz arbeitenden weiteren Impuls-Weiten-Modulators angeschlossen ist, wird die entsprechende Auswertung dieses Pulsweitensignals vorgenommen. Dabei erfolgt die Frequenzsteuerung von außen; eine solche Anordnung ist somit von einem merklichen dreieckförmigen Signalverlauf am Ausgang des Integrators nicht abhängig. Die Schaltung mit dem Integrator arbeitet daher als Filter; der weitere Impuls-Weiten-Modulator hat somit die Funktion eines Hilfsmodulators.

Eine Anordnung nach der Erfindung kann so weitergebildet sein, daß der erste Schalter ein Umschalter ist, über den die zweite Eingangsgröße abwechselnd dem Eingang des ersten Integrators oder dem Eingang des zweiten Integrators zugeführt wird, und daß der zweite Schalter ein Umschalter ist, über den dem zweiten Integrator abwechselnd ein erster oder ein zweiter, vorzugsweise entgegengesetzt gleicher, Einstellstrom zugeführt wird, und daß zwischen den Eingängen und den Ausgängen des ersten und des zweiten Integrators je eine Reihenschaltung eines ersten und eines zweiten bzw. eines dritten und eines vierten Stabilisierungs-Widerstandes angeschlossen ist, deren Abgriffpunkte mit dem Eingang bzw. mit dem Ausgang eines Verstärkers verbunden sind derart, daß die Symmetrie der Anordnung stabilisiert wird. Dadurch wird die Schaltung in sich symmetriert und ist von Toleranzabweichungen der verwendeten Schaltelemente weniger abhängig, was insbesondere bei temperatur- und zeitabhängigen Schwankungen wichtig ist. Eine weitere Verbesserung ist dadurch möglich, daß dem ersten Impuls-Weiten-Modulator Impulszüge entgegengesetzter Polarität entnommen werden, die abwechselnd über einen von einer dritten Antriebsvorrichtung entsprechend einer fünften Taktfrequenz betätigten dritten Umschalter die erste Antriebsvorrichtung für den ersten Umschalter steuern, und daß die Ausgangskontakte des zweiten Umschalters über einen, von der dritten Antriebsvorrichtung betätigten Kreuzschalter abwechselnd mit den Eingängen des ersten und des zweiten Integrators verbunden werden. Der dritte Umschalter arbeitet dann nach Art eines Choppers und bewirkt, daß auftretende Fehler in aufeinanderfolgenden Intervallen der vierten Taktfrequenz entgegengesetztes Vorzeichen bekommen und sich somit aufheben können.

Ausführungsbeispiele der Erfindung werden nachstehend anhand der Zeichnung näher erläutert. Es zeigen
- **Fig.** 1 und 2: den vorstehend beschriebenen Stand der Technik,
- **Fig.** 3: ein Ausführungsbeispiel der Erfindung,
- **Fig.** 4: ein verbessertes Ausführungsbeispiel der Erfindung,
- **Fig.** 5: eine weitere verbesserte Ausführungsvariante, und
- **Fig.** 6: in den Schaltungen auftretende Spannungs- bzw. Strom-Verläufe über der Zeit.

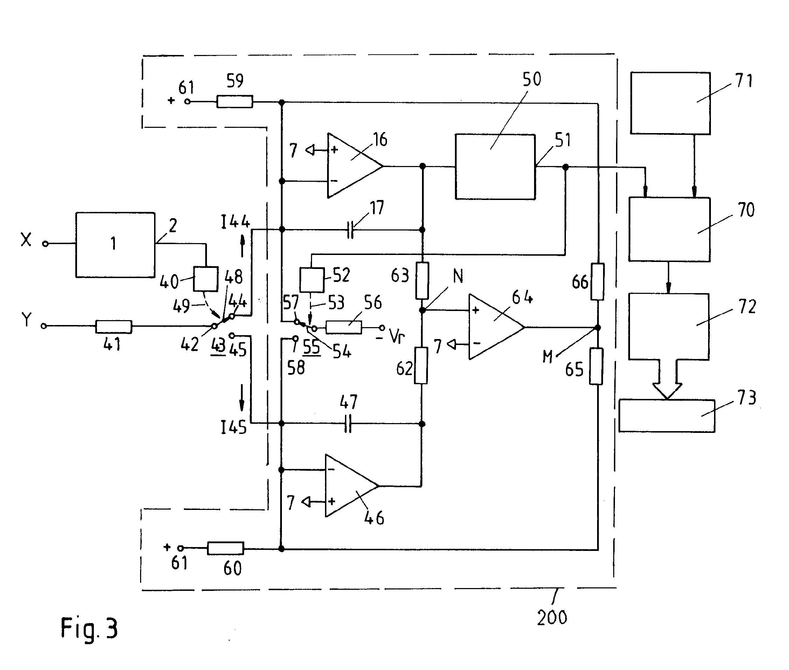

In der Ausführungsform der Erfindung nach Figur 3 steuert die erste Eingangsgröße X über den Impuls-Weiten-Modulator 1 mit seinem Ausgang 2 eine dritte Antriebsvorrichtung 40. Die zweite Eingangsgröße Y wird über einen Widerstand 41 dem Eingangskontakt 42 eines vierten Umschalters 43 zugeführt. Dessen Ausgangskontakte 44 bzw. 45 sind mit dem Eingang des ersten Integrators 16,17 bzw. dem Eingang eines, aus dem Verstärker 46 und dem Kondensator 47 gebildeten zweiten Integrators verbunden. Die Schaltverbindung 48 des Umschalters 43 wird mittels einer Verbindung 49 von der dritten Antriebsvorrichtung 40 periodisch im Maße der Impuls-Weiten-Modulation hin- und hergeschaltet und führt somit die erste Eingangsgröße über den Widerstand 41 entweder dem ersten Integrator 16,17 oder dem zweiten Integrator 46,47 zu.

Am Ausgang des ersten Integrators 16,17 tritt eine durch Integration der zugeführten Impulse hervorgerufene Dreieckspannung auf, die einen Komparator 50 steuert. Wenn die etwa dreieckförmig verlaufende Eingangsspannung am Komparator 50 einen Grenzwert, ggf. mit einer gewissen Hysterese, überschreitet oder unterschreitet, tritt am Ausgang 51 eine entsprechende impulsartig hin-und herschaltende Spannung auf. Diese wird einer Antriebsvorrichtung 52 zugeführt, die über eine Antriebs-Verbindung 53 die Schaltverbindung 54 eines fünften Umschalters 55 betätigt. Die Schaltverbindung 54 des Umschalters 55 ist über einen Widerstand 56 an eine negative Vorspannung -Vr angeschlossen; die Gegenkontakte 57 und 58 sind mit den Eingängen der Integratoren 16, 17 bzw. 46, 47 verbunden. Diese Eingänge sind weiter über Widerstände 59 bzw. 60 an eine positive Vorspannung 61 angeschlossen. Mittels des Umschalters 55 wird somit die Grundeinstellung der Verstärker 16 und 46 zwischen einem positiven und einem negativen Wert hin- und hergeschaltet; bei dieser Eigensteuerung werden vom Umschalter 43 her die mit dem Produkt der Eingangsgrößen X und Y in Amplitude und Weite modulierten Signale zugeführt. Wenn die dadurch am Ausgang des Integrators 16, 17 hervorgerufene dreieckförmige Spannung am Eingang des Komparators 50 einen Grenzwert, ggf. mit einer bestimmten Hysterese, überschreitet bzw. unterschreitet, geht die Spannung am Ausgang 51 des Komparators 50 impulsartig nach oben bzw. nach unten, so daß ein Verlauf entsteht, der, unabhängig von der Amplitude, in seiner Impuls-Weiten-Modulation das Produkt der Eingangsgrößen X und Y enthält.

Der Integrator 16,17, der Komparator 50 und der von dessen Ausgang 51 her gesteuerte Umschalter 55 bilden zusammen mit der Referenzspannung -Vr und der positiven Spannung 61 sowie den Widerständen 56 und 59 einen an sich bekannten Impuls-Weiten-Modulator.

Um die bei bekannten Anordnungen durch die Schalter verursachten Probleme zu beseitigen oder wenigstens zu vermindern, wurde der weitere Integrator 46,47 eingeführt. Dessen Ausgang ist über die Reihenschaltung eines ersten Widerstandes 62 und eines zweiten Widerstandes 63 mit dem Ausgang des ersten Integrators 16,17 verbunden, und an den Abgriff zwischen den Widerständen 62 und 63 ist der Eingang eines Verstärkers 64 angeschlossen. Dessen Ausgang liegt am Abgriff M zwischen einem dritten Widerstand 65 und einem vierten Widerstand 66, die in Reihe zwischen die Eingänge der Integratoren 46,47 und 16,17 angeschaltet sind. Da die Ausgänge der beiden Integratoren entgegengesetzt verlaufende Dreiecksspannungen führen, tritt am Abgriffpunkt N zwischen den Widerständen 62 und 63 eine von den dreieckförmigen Spannungsschwankungen freie Gleichspannung auf, die über den Verstärker 64 zur Stabilisierung der Arbeitspunkte der Verstärker 16 und 46 zurückgeführt wird. Gleichzeitig wird das Problem störender Ladungsinjektionen an den Schaltern 43 und 55 behoben; denn die Ladungsinjektion ist dann am kleinsten, wenn die Verstärker 16 und 46 in gleicher bzw. symmetrischer Konfiguration zu den Schaltern 43 und 55 angeordnet sind. Wenn die Eingangsinformationen X und Y auftreten, fließen vom Schalter 43 abwechselnd gleiche, aber entgegengesetzte Eingangsströme I44 und I45 in die beiden Integratoren 16,17 bzw. 46,47; die Ausgangsspannung am Verstärker 46 und entsprechend auch am Verstärker 16 bleibt stabil.

Wenn die Eingangsströme I44 und I45 infolge von Fehlereinflüssen nicht entgegengesetzt gleich sind oder das System durch Differenzen in den Widerständen oder Offset-Spannungen der Verstärker unsymmetrisch sind, beginnt die Ausgangsspannung vom Verstärker 46 und die Spannung am Punkt N zwischen den Widerständen 62 und 63 auszuwandern. Um eine Sättigung der Verstärker zu vermeiden, wird das Auswandern kontrolliert. An sich könnte man schon die Ausgangsspannung des Verstärkers 16 allein dazu verwenden, jedoch müßte dann durch Filter die dreieckförmige Amplitudenänderung beseitigt werden. In der dargestellten Schaltung führt der Punkt N diese dreieckförmige Spannungsänderung nicht, so daß ein Filter vermieden und der Verstärker 64 über die dargestellten Widerstände direkt mit dem Eingang der Integratoren verbunden sein kann. So wird die Symmetrie der Eingangsströme in einfacher Weise hergestellt und eine Übersteuerung des Integrator-Verstärkers 16 vermieden. Es zeigen sich auch keinerlei Schwingneigungen, wie sie insbesondere bei Verwendung üblicher Filter leicht möglich sind.

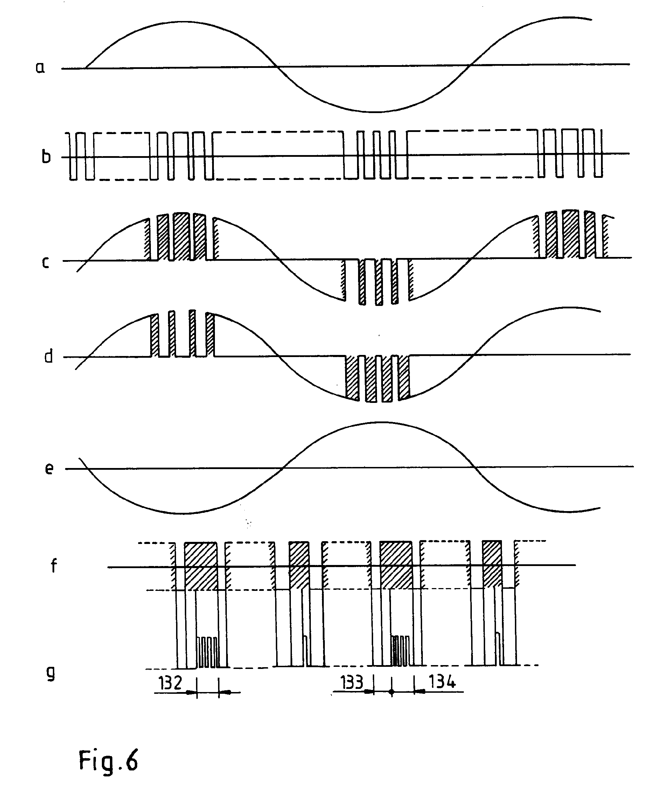

Um das Produkt von X und Y, das im Signal vom Ausgang 51 gemäß Figur 6b als Impuls-Weiten-Modulation enthalten ist, in Impulse überzuführen, deren Frequenz der Zahl von Energieanteilen entspricht, die z.B. ein Zählwerk steuern sollen, werden diese Ausgangsimpulse einem Schieberegister 70 zugeführt, das außerdem zeitgenau über Taktimpulse von einem Generator 71 gesteuert wird. Das Schieberegister wird durch die Zähltakte vorwärts oder rückwärts geschoben, je nachdem, ob die Impulse während der Impulszeit oder während der Pausenzeit des Signals vom Ausgang 51 in das Register eingeschoben werden. Das Ergebnis ist, wie bei einem Spannungs-Frequenz-Umsetzer mit einer monostabilen Kippstufe gemäß Figur 1 oder 2, eine dem Produkt (X * Y) entsprechende Ausgangs-Impulsfolge, die, im Gegensatz zu den Figuren 1 und 2, allerdings digital gebildet wird und somit von Ungenauigkeiten eines analogen Grenzwertes unabhängig ist. Die Schaltung arbeitet auch, wenn das erwähnte Produkt gleich Null ist, wenn also auch die Differenz zwischen den vorwärts und den rückwärts gezählten Impulsen Null ist. Ein geringes Energiequantum wird jedoch festgehalten und mit weiteren Energiequanten allmählich summiert, bis schließlich der Grenzwert erreicht ist und vom Ausgang des Schieberegisters 70 an eine Verarbeitungsstufe 71 und weiter an eine Zähler- oder Anzeigestufe 72 abgegeben wird.

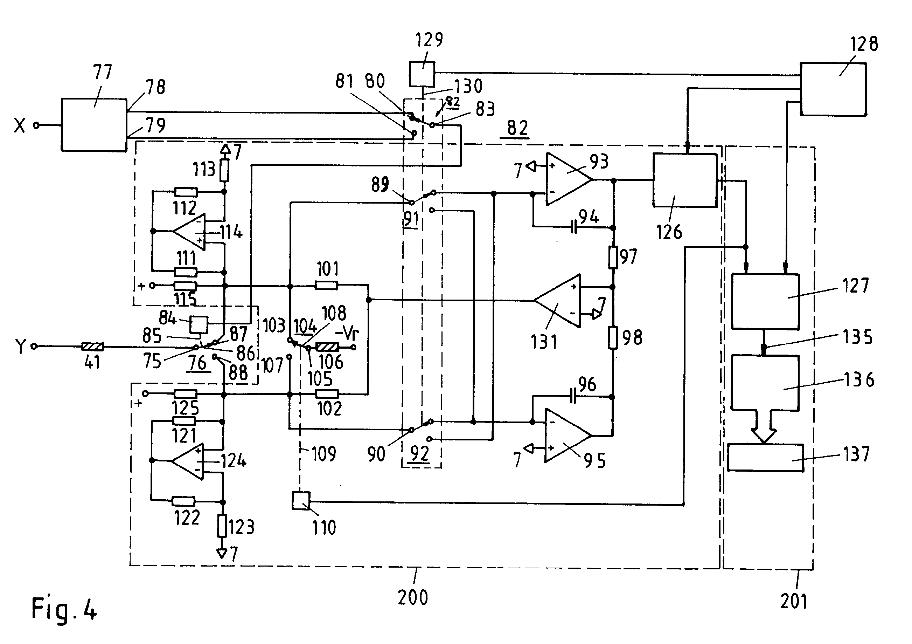

Figur 4 zeigt eine abgeänderte Ausführungsform der Erfindung, bei der mit einem Choppersystem und einem geänderten Quantisierer weitere Verbesserungen erzielt werden.

Die zweite Eingangsgröße Y wird über einen Widerstand 41 dem Eingangskontakt 75 eines sechsten Umschalters 76 zugeführt.

Die erste Eingangsgröße X wird einem Impuls-Weiten-Modulator 77 zugeführt, der zwei Ausgänge 78 und 79 aufweist, an denen das modulierte Signal mit entgegengesetzter Polarität auftritt und die mit den Kontakten 80 und 81 eines siebenten Umschalters 82 zugeführt werden. Der Ausgangskontakt 83 ist mit einer Antriebsvorrichtung 84 verbunden, die über eine Antriebsverbindung 85 die Schaltverbindung 86 des sechsten Umschalters 76 betätigt. Dadurch wird der Eingangskontakt 75 über die Schaltverbindung 86 abwechselnd verbunden mit den Ausgangskontakten 87 und 88 und dadurch mit den Eingangskontakten 89 und 90 des achten Umschalters 91 und des neunten Umschalters 92. Deren Ausgänge sind nach Art eines Kreuzschalters verbunden und an die Eingänge eines aus einem Verstärker 93 und einem Kondensator 94 und eines aus einem Verstärker 95 und einem Kondensator 96 bestehenden Integrators angeschlossen. Zwischen den Ausgängen der Verstärker 93 und 95 liegt die Reihenschaltung eines fünften Widerstandes 97 und eines sechsten Widerstandes 98, und zwischen den Eingangsklemmen 89 und 90 der Schalter 91 bzw. 92 ist die Reihenschaltung eines siebenten Widerstandes 101 und eines achten Widerstandes 102 angeschlossen. Die Eingangsklemme 89 ist weiter mit einer Ausgangsklemme 103 eines zehnten Umschalters 104 verbunden, dessen Eingangsklemme 105 über einen Widerstand 106 an eine negative Referenzspannung -Vr angeschlossen ist. Die andere Ausgangsklemme 107 des Umschalters 104 liegt am Eingangskontakt 90 des Umschalters 92. Die Schaltverbindung 108 des Umschalters 104 wird über eine Antriebsverbindung 109 von der Antriebsvorrichtung 110 her betätigt, die vom Ausgang des Modulators 126 gesteuert wird.

Zwischen dem Eingangskontakt 89 des Umschalters 91 und dem Bezugspotential 7 ist eine an sich bekannte Stromquellenschaltung angeordnet, die aus der Reihenschaltung dreier Widerstände 111,112 und 113 besteht, wobei die Klemme 87 mit der positiven und der Abgriff zwischen den Widerständen 112 und 113 mit der negativen Eingangsklemme eines Verstärkers 114 verbunden ist, dessen Ausgang am Verbindungspunkt der Widerstände 111 und 112 liegt. Der Eingang dieser Stromquellenschaltung liegt außerdem über einen Widerstand 115 am positiven Pol + einer Speisequelle. Eine gleichartig ausgebildete Stromquellenschaltung mit den Widerständen 121,122,123 und 125 sowie mit einem Verstärker 124 liegt zwischen der Eingangsklemme 90 des Umschalters 92 und dem Bezugspotential 7.

Der Ausgang des Integrators 93,94 steuert einen Hilfs-Impuls-Weiten-Modulator 126, dessen Ausgangssignale einem Schieberegister 127 und der Antriebsvorrichtung 110 für den Schalter 104 zugeführt werden. Dadurch, daß der Impuls-Weiten-Modulator 126 anstelle des Komparators 50 in Figur 3 eingesetzt ist, braucht die Steuerung der Puls-Weiten-Modulation nicht unter Mitwirkung des Integrators 93,94 vorgenommen zu werden. Die Zeitkonstante dieses Integrators kann daher zur Unterdrückung von störenden Einflüssen mit herangezogen werden. Für eine exakte Funktion werden einem Taktgeber 128, ausgehend von einem Quarzgenerator, sehr genaue Zeitbasissignale entnommen, die, z.B. mit einer Frequenz von 1 kHz, den Modulator 126 und andererseits mit einer Taktfrequenz von 30 kHz das Schieberegister 127 steuern.

Dem Taktgenerator 128 wird weiter das Taktsignal für eine Antriebsvorrichtung 129 entnommen, die über eine gemeinsame Antriebsverbindung 130 die Schaltverbindungen für die gekuppelten Umschalter 82,91 und 92 mit einer Frequenz von z.B. 4 Hz betätigt. In der dargestellten Schaltung bilden diese drei Umschalter somit eine Choppereinrichtung, infolge der das Nutzsignal die Schaltung abwechselnd in entgegengesetzter Richtung durchläuft derart, daß auftretende Fehler sich über mehrere Chopperperioden gemittelt ausgleichen und so eine noch exaktere Bildung des gewünschten Produktes der Eingangsgrößen X und Y erhalten wird. Voraussetzung dafür sind gleiche Verweilzeiten der Schalter in den beiden Chopperpositionen. Restliche Unsymmetrie im System, z.B. infolge nicht gleicher Schalterwiderstände der Schalter 91 und 92 oder durch verschiedene Offsetspannungen der Integratoren 93 und 95, werden mit Hilfe der Stromquellenschaltungen mit den Verstärkern 114 bzw. 124 ausgeglichen.

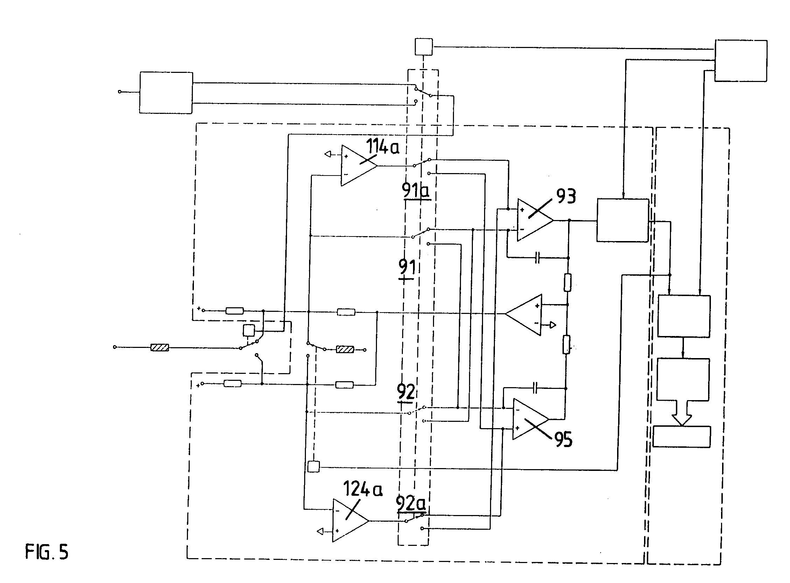

Eine andere Variante zeigt Fig. 5 auf. Anstelle der Stromquellenschaltungen mit den Verstärkern 114 bzw. 124 sind die Verstärker 114a und 124a eingesetzt. Sie ermöglichen, daß sich die Widerstände der Umschalter 91 und 92 nicht auswirken. Das ursprüngliche Bezugspotential 7 der Integratorverstärker 93 und 95 wird von den Verstärkern 114a und 124a derart gesteuert, daß der Spannungsabfall über den Schaltwiderständen der Umschalter 91 und 92 ausgeregelt wird.

Um die Unsymmetrien der Verstärker 114a und 124a in das Choppersystem mit einzubeziehen, sind die Umschalter 91a und 92a eingesetzt, die auch die Ausgänge der Verstärker abwechselnd im Choppertakt umschalten.

Sind die Eingangsinformationen X und Y sinusförmige Meßgrößen, z.B. X die Ausgangsspannung eines Stromwandlers in der Zuleitung eines Elektrizitätsabnehmers und Y die zum Strom gehörende Netzspannung gleicher Frequenz, so ergibt sich als Resultat der in Figur 4 dargestellten Schaltung mit Zwei-Quadranten-Multiplikation folgendes:

Neben dem frequenz-unabhängigen mittleren Leistungswert, der insbesondere in Form einer schwankenden Gleichstromgröße auftritt, sind normalerweise auch Komponenten mit Meßfrequenz (Netzfrequenz) und doppelter Meßfrequenz vorhanden. Zwischen dem Verbindungspunkt der Widerstände 97 und 98 und dem Verbindungspunkt der Widerstände 101 und 102 ist ein Stabilisierungsverstärker 131 angeschlossen, dessen zweiter Eingang am Bezugspotential 7 liegt. Die gegenwirkende Rückkopplung über diesen Verstärker 131 verhindert die Ausbildung von Komponenten mit Meßfrequenz vollständig. Der Anteil mit doppelter Meßfrequenz, der bei der Multiplikation auftritt, kann aber in der Darstellung der Ausgangsinformation ungewollte Schwankungen produzieren.

In Figur 6 sind die Charakteristika der verschiedenen Eingangs- und Ausgangsgrößen aus Figur 4 und Fig. 5 dargestellt.

In seiner Figur 6a ist eine sinusförmig verlaufende Welle der Eingangsgröße X, z.B. des Stromes eines Elektrizitäts-Abnehmers, dargestellt, die gemäß Figur 6b am Ausgang 2 des Pulsmodulators 1 als impulsweiten-modulierte Welle mit konstanter Amplitude auftritt.

Die Eingangsgröße X gemäß Figur 6a wird in der Stufe 77 in eine Impuls-Weiten-Modulation nach Figur 6b umgesetzt und nach Multiplikation mit der Eingangsgröße Y im Schalter 57 gemäß Figur 6c und 6d mit entgegengesetzter Polarität den Integratoren 93,94 bzw. 95,96 - mit absatzweise durch den Chopper 82,91,92 geänderten Stromwegen - zugeführt. Die im Ausgangssignal auftretende Komponente mit Netzfrequenz nach Figur 6e wird über den Verstärker 131 ausgeglichen.

Damit Anzeigeschwankungen mit doppelter Meßfrequenz vermindert oder vermieden sind, werden die Meßwerte in den Integratoren 93, 94 und 95, 96 durch entsprechende Kondensatoren gespeichert; der Mittelwert der Schwankungen mit doppelter Meßfrequenz ist Null und damit kein Problem. Dann steuert lediglich die Ausgangsgleichspannung des Integrators 93, 94, die dem gewünschten Produkt entspricht, die Impulsweite des Hilfs-Impuls-Weiten-Modulators 126 (vgl.Fig.6f); die Nulldurchgänge einer am Ausgang des Integrators 93, 94 auftretenden Dreieckspannung, die in Figur 3 für die Steuerung des Komparators ausgenutzt werden, sind in Figur 4 ohne Bedeutung.

Die erhaltenen, in der Impulsbreite bzw. der Impulspause modulierten Impulszüge nach Figur 6f werden durch das Schieberegister 127 mit einer vom Taktgeber 128 gegebenen Frequenz von z.B. 30 kHz oder aber auch einer sehr viel höheren Frequenz von bis z.B. 4 MHz ausgezählt. Es ergeben sich dabei Signalverläufe gemäß Figur 6g. Dabei erfolgt z.B. im Intervall 132 eine Aufwärtszählung. Diese wird im nächsten Intervall beendet, und es erfolgt in nicht dargestellter Weise eine Abwärtszählung. Diese wird zu Anfang des nächsten Intervalles, wie z.B. bei 133 zu entnehmen ist, zunächst wieder ausgeglichen, ohne daß eine weitere Aufwärtszählung einsetzt. Erst wenn dieser Ausgleich durchgeführt ist, wird weiter aufwärts gezählt, wie bei 134 erkennbar ist. Wenn schließlich die Aufwärtszählung einen bestimmten Wert erreicht hat, wird am Ausgang des Schieberegisters 127 über die Verbindung 135 der folgenden Verarbeitungsstufe 136 ein Impuls zugeführt, der einen bestimmten Wert des Produktes (X * Y) darstellt und als Energiequant an ein Zählwerk 137 oder eine andere Anzeigevorrichtung weitergegeben werden kann. Die in der Verbindung 135 übertragene Impulsfolge stellt in der Zeiteinheit einen Leistungswert dar, der ebenfalls angezeigt werden kann.

Mit einer solchen Anordnung nach der Erfindung kann eine deutlich höhere Genauigkeit und bessere Flexibilität bei der Herstellung einer Impuls-Weiten-Modulation für das Produkt der Eingangsgrößen X und Y erhalten werden; dies gilt insbesondere, wenn die Eingangsgröße X den Strom eines Elektrizitäts-Abnehmers und die Eingangsgröße Y der zugehörigen Netzspannung entspricht. Besonderer Vorzug einer solchen Schaltung ist, daß auch das Vorzeichen des Produktes, insbesondere die Richtung eines Energieflusses, berücksichtigt werden kann und daß ein genauer Nullpunkt erhalten wird und geringe Schwankungen der Ausgangsfrequenz auftreten, wobei dennoch eine gute Sprungantwort des Regelsystems erzielt wird. Dabei ist lediglich eine Referenzspannung -Vr erforderlich, die besondere Abgleiche nicht notwendig macht.

Eine Anordnung nach der Erfindung führt auch zu einer wirtschaftlichen Lösung des Problems, da viele Funktionen in wenigen Elementen zusammengefaßt werden. Die Anordnung läßt sich auch ohne Schwierigkeiten mit Halbleiter-Integrationstechnik miniaturisieren. Für die Filterwirkung, insbesondere gegenüber Änderungen der doppelten Meßfrequenz, sind nur Kondensatoren gängiger Größe, z.B. in der Größenordnung von einem Mikrofarad bei Eingangsfrequenzen von 50 Hz, erforderlich.

Die Ausführungsbeispiele sind mit nur zwei Eingängen, d.h. z.B. einer Phase eines Drehstromnetzes, dargestellt und beschrieben. Die Anordnungen können ohne weiteres mehrphasig ausgelegt werden, indem z.B. in Figur 4 der ImpulsWeiten-Modulator 77, die Chopperschaltung 82,91 und 92, der Eingangswiderstand 41 und der Multiplizierschalter 76 vervielfacht werden. Die Ausgänge der Schalter 76 können parallelgeschaltet werden, und ihre Schaltverbindungen werden von den unterschiedlichen Modulatoren 77 angesteuert.

### Bezugszeichenliste:

- Impuls-Weiten-Modulator: 1
- Ausgang: 2
- Widerstände: 3, 4, 5, 6
- Allg. Bezugspotential: 7
- Verstärker: 8
- Eingangskontakte: 9, 10
- Umschalter: 11
- Schaltverbindung: 12
- Ausgangskontakt: 13
- Erste Antriebsvorrichtung: 14
- Verbindung: 15
- Verstärker: 16
- Kondensator: 17
- Erster Integrator: 16, 17
- Kippglied: 18
- Zweite Antriebsvorrichtung: 19
- Widerstand: 21
- Schaltverbindung: 22
- Eingangskontakte: 23, 24
- Verbindung: 25
- Ausgang: 26
- Dritter Umschalter: 27
- Eingangskontakt: 28
- Vorwiderstand: 29
- Ausgangskontakte: 30, 31
- Widerstände: 32, 33
- Verstärker: 34
- Eingang: 35
- Dritte Antriebsvorrichtung: 40
- Widerstand: 41
- Eingangskontakt: 42
- Vierter Umschalter: 43
- Ausgangskontakte: 44, 45
- Verstärker: 46
- Kondensator: 47
- Zweiter Integrator: 46, 47
- Schaltverbindung: 48
- Antriebs-Verbindung: 49
- Komparator: 50
- Zweiter Impuls-Weiten-Modulator: 50, 51, 55, 56, 59
- Ausgang: 51
- Fünfte Antriebsvorrichtung: 52
- Antriebs-Verbindung: 53
- Schaltverbindung: 54
- Fünfter Umschalter: 55
- Widerstand: 56
- Kontakte: 57, 58
- Widerstände: 59, 60
- Pos. Spannung: 61
- Erster Widerstand: 62
- Zweiter Widerstand: 63
- Verstärker: 64
- Dritter Widerstand: 65
- Vierter Widerstand: 66
- Schieberegister: 70
- Taktgeber: 71
- Verarbeitungsstufe: 72
- Anzeigefeld: 73
- Eingangskontakt: 75
- Sechster Umschalter: 76
- Impuls-Weiten-Modulator: 77
- Ausgänge: 78, 79
- Kontakte: 80, 81
- Siebenter Umschalter: 82
- Ausgangskontakt: 83
- Sechste Antriebsvorrichtung: 84
- Antriebsverbindung: 85
- Schaltverbindung: 86
- Ausgangskontakte: 87, 88
- Eingangskontakte: 89, 90
- Achter Umschalter: 91
- Umschalter: 91a
- Neunter Umschalter: 92
- Umschalter: 92a
- Verstärker: 93
- Erster Integrator: 93, 94
- Kondensator: 94
- Verstärker: 95
- Kondensator: 96
- Fünfter Widerstand: 97
- Sechster Widerstand: 98
- Siebenter Widerstand: 101
- Achter Widerstand: 102
- Ausgangsklemme: 103
- Zehnter Umschalter: 104
- Eingangskontakt: 105
- Widerstand: 106
- Ausgangsklemme: 107
- Schaltverbindung: 108
- Antriebsverbindung: 109
- Antriebsvorrichtung: 110
- Widerstände: 111, 112, 113, 115
- Verstärker: 114
- Verstärker: 114a
- Widerstände: 121, 122, 123, 125
- Verstärker: 124
- Verstärker: 124a
- Impuls-Weiten-Modulator: 126
- Schieberegister: 127
- Taktgeber: 128
- Intervall: 132
- Intervall: 133
- Intervall: 134
- Verbindung: 135
- Verarbeitungsstufe: 136
- Zählwerk: 137

## Patentansprüche

1. Anordnung zum Bilden eines Produktsignals (P = X * Y), bei der eine erste Eingangsgröße (X) über einen ersten, mit einer ersten Taktfrequenz arbeitenden Impuls-Weiten-Modulator (1; 77) einen ersten Schalter (11; 43; 76) betätigt, über den eine zweite Eingangsgröße (Y) einem zu einem Quantisierer (200) gehörenden ersten Integrator (16, 17; 93, 94) zugeführt wird, wobei an dem Ausgang (51) des Quantisierers (200) Impulse mit einer dem Produkt (X * Y) entsprechenden Frequenz auftreten,
dadurch gekennzeichnet,
daß der erste Integrator (16, 17; 93, 94) einen Teil eines zweiten, mit einer zweiten Taktfrequenz arbeitenden Impuls-Weiten-Modulators (50, 51, 55, 56, 59) bildet, dessen Ausgangsimpulse einerseits einen zweiten Schalter (55; 104) betätigen, über den dem ersten Integrator (16, 17; 93, 94) abwechselnd ein erster oder ein zweiter, vorzugsweise entgegengesetzt gleicher, Einstellstrom zugeführt wird, und andererseits ein mit einer dritten Taktfrequenz aufwärts bzw. abwärts zählendes Schieberegister (70; 127) steuern, das bei Erreichen eines Grenzwertes die Impulse mit der dem Produkt entsprechenden Frequenz liefert, und daß der zweite Impuls-Weiten-Modulator (50, 51, 55, 56, 59) einen zweiten Integrator (46, 47; 95, 96) umfaßt.

2. Anordnung nach Anspruch 1,
dadurch gekennzeichnet,
daß der Ausgang des ersten Integrators (16, 17) an den Eingang eines Komparators (50) des zweiten Impuls-Weiten-Modulators angeschlossen ist, der die Ausgangsimpulse für den zweiten Schalter (55) und für das Schieberegister (70) liefert (Fig. 3).

3. Anordnung nach Anspruch 1,
dadurch gekennzeichnet,
daß der Ausgang des ersten Integrators (93, 94) an den Eingang eines mit einer vierten Taktfrequenz arbeitenden dritten Impuls-Weiten-Modulators (126) angeschlossen ist, der die Ausgangsimpulse für den zweiten Schalter (104) und für das Schieberegister (127) liefert (Fig. 4).

4. Anordnung nach Anspruch 1, 2 oder 3,
dadurch gekennzeichnet,
daß der erste Schalter (43) ein Umschalter ist, über den die zweite Eingangsgröße (Y) abwechselnd dem Eingang des ersten Integrators (16,17) oder dem Eingang des zweiten Integrators (46,47) zugeführt wird, und daß der zweite Schalter (55) ein Umschalter ist, über den dem zweiten Integrator (46,47) abwechselnd ein erster oder ein zweiter, vorzugsweise entgegengesetzt gleicher, Einstellstrom zugeführt wird, und daß zwischen den Eingängen und den Ausgängen des ersten und des zweiten Integrators je eine Reihenschaltung eines ersten und eines zweiten bzw. eines dritten und eines vierten Stabilisierungs-Widerstandes (62,63,64,65) angeschlossen ist, wobei der Abgriffpunkt (N) zwischen dem ersten und dem zweiten Widerstand (62,63) mit dem Eingang bzw. der Abgriffpunkt (M) zwischen dem dritten und dem vierten Widerstand (65,66) mit dem Ausgang eines Verstärkers (64) verbunden sind derart, daß die Symmetrie der Anordnung stabilisiert wird.

5. Anordnung nach Anspruch 4,
dadurch gekennzeichnet,
daß dem ersten Impuls-Weiten-Modulator (77) Impulszüge entgegengesetzter Polarität entnommen werden (bei 78, 79), die abwechselnd über einen von einer Antriebsvorrichtung (129) entsprechend einer fünften Taktfrequenz betätigten dritten Umschalter (82) eine Antriebsvorrichtung (84) für den ersten Umschalter (76) steuern, und daß die Ausgangskontakte des zweiten Umschalters (104) über einen, von der Antriebsvorrichtung (129) für den dritten Umschalter (82) betätigten Kreuzschalter (91,92) abwechselnd mit den Eingängen des ersten und des zweiten Integrators (93,94,95,96) verbunden werden (Fig. 4).

6. Anordnung nach einem der vorangehenden Ansprüche 2 bis 5,
dadurch gekennzeichnet,
daß die dritte, vierte und fünfte Taktfrequenz phasenstarr gekoppelt von einem, vorzugsweise quarzgesteuerten, Taktgenerator (128) geliefert werden.

7. Anordnung nach einem der vorangehenden Ansprüche,
dadurch gekennzeichnet,
daß die vierte Taktfrequenz in der Größenordnung des Zehnfachen der Meßfrequenz liegt und z.B. bei einer Netzfrequenz von 50 Hz 300 bis 2.000, vorzugsweise 1.000 Hz, beträgt.

8. Anordnung nach einem der vorangehenden Ansprüche,
dadurch gekennzeichnet,
daß die dritte Taktfrequenz für das Schieberegister im Bereich von 30 kHz bis 4 MHz liegt.

9. Anordnung nach einem der vorangehenden Ansprüche,
dadurch gekennzeichnet,
daß die fünfte Taktfrequenz für die Antriebsvorrichtung für den dritten Umschalter (82) etwa 1 bis 6, beispielsweise 4 Hz, beträgt.

## Claims

1. Device for forming a product of signals (P= X * Y), wherein a first input variable (X) actuates, by means of a first pulse width modulator (1;77) operating with a first clock frequency, a first switch (11;43; 76), via which a second input variable (Y) is suuplied to a first integrator (16,17;93,94) forming part of a quantizer (200), in which case, at the output (51) of the quantizer (200), pulses occur with a frequency corresponding to the product (X * Y),
**characterized in that**
the first integrator (16,17;93,94) forms a part of a second pulse width modulator (50,51,55,56,59) operating with a second clock frequency, whose output pulses, on the one hand, actuate a second switch (55;104), via which a first or a second, preferably inverse identical adjusting current is alternately supplied to the first integrator (16,17;93,94) and, on the other hand, control a shift register (70;127) counting upwardly or downwardly with a third clock frequency, which, when reaching a limit value, supplies the pulses with the frequency corresponding to the product and in that the second pulse width modulator (50,51,55,56,59) comprises a second integrator (46,47;95,96).

2. Device according to Claim 1,
**characterized in that**
the output of the first integrator (16,17) is connected to the input of a comparator (50) of the second pulse width modulator which supplies the output pulses for the second switch (55) and for the shift register (70) (Fig.3).

3. Device according to Claim 1,
**characterized in that**
the output of the first integrator (93,94) is connected to the input of the third pulse width modulator (126) operating with a fourth clock frequency, which supplies the output signals for the second switch (104) and for the shift register (127) (Fig.4).

4. Device according to either Claim 1, 2 or 3,
**characterized in that**
the first switch (43) is a change-over switch, by means of which the second input variable (Y) is alternately supplied to the input of the first integrator (16,17) or to the input of the second integrator (46,47) and in that the second switch (55) is a change-over switch, by means of which, via the second integrator (46,47), a first or a second, preferably inverse identical adjusting current is supplied and in that, between the outputs of the first and the second integrator, one series connection of a first and of a second or of a third and of a fourth stabilizing resistor (62,63,64, 65) is connected, in which case the tapping point (N) between the first and the second resistor (62,63) is connected to the input or the tapping point (M) between the third and the fourth resistor (65,66) with the output of an amplifier (64) in such a way that the symmetry of the device is stabilized.

5. Device according to Claim 4,
**characterized in that**
pulse trains possessing inverse polarity are removed from the first pulse width modulator (77) (at 78,79), which alternately control, by means of a third changeover switch (82) actuated according to a fifth clock frequency by a driving means (129), a driving means (84) for the first change-over switch (76) and in that the output contacts of the second change-over switch (104) are alternately connected with the inputs of the first and the second integrator (93,94, 95,96) by means of an intermediate switch (91,92) actuated by the driving means (129) for the third change-over switch (82).

6. Device according to any of the preceding Claims 2 to 5,
**characterized in that**
the third, fourth and fifth clock frequencies are supplied phaselocked coupled from a preferably quartz-controlled clock generator (128).

7. Device according to any of the preceding claims,
**characterized in that**
the fourth clock frequency is in the order of magnitude of the tenfold of the measuring frequency and, e.g. at a mains frequency of 50 Hz, is 300 to 2000, by preference 1000 Hz.

8. Device according to any of the preceding claims,
**characterized in that**
the third clock frequency for the shift register is within the range of 30 kHz to 4 MHz.

9. Device according to any of the preceding claims,
**characterized in that**
the fifth clock frequency for the driving means for the third change-over switch (82) is approximately 1 to 6, by way of example, 4 Hz.

## Revendications

1. Dispositif pour former un signal de produit (P = X * Y), pour lequel une première grandeur d'entrée (X) actionne, par l'intermédiaire d'un premier modulateur d'impulsions en largeur (1 77) qui fonctionne avec une première fréquence de cycles, un premier commutateur (11 ; 43 ; 76), par lequel une seconde grandeur d'entrée (Y) est amenée à un premier intégrateur (16, 17 ; 93, 94) qui fait partie d'un quantificateur (200), des impulsions avec une fréquence qui correspond au produit (X * Y) intervenant à la sortie (51) du quantificateur (200),
**caractérisé en ce**
que le premier intégrateur (16, 17 ;93, 94) forme une partie d'un second modulateur d'impulsions en largeur (50, 51, 55, 56, 59), qui fonctionne avec une seconde fréquence de cycles, dont les impulsions de sortie actionnent, d'une part, un second commutateur (55 ; 104) par lequel un premier ou un second courant de réglage, de préférence égal en étant opposé, est amené en alternance au premier intégrateur (16, 17 ; 93, 94) et commandent, d'autre part, un registre à décalage (70 ; 127) qui compte et/ou décompte avec une troisième fréquence de cycles, registre qui, lorsqu'une valeur de seuil est atteinte, fournit les impulsions avec la fréquence qui correspond au produit, et que le second modulateur d'impulsions en largeur (50, 51, 55, 56, 59) comprend un second intégrateur (46, 47 95, 96).

2. Dispositif selon la revendication 1,
**caractérisé en ce**
que la sortie du premier intégrateur (16, 17) est raccordée à l'entrée d'un comparateur (50) du second modulateur d'impulsions en largeur qui fournit les impulsions de sortie pour le second commutateur (55) et pour le registre à décalage (70) (fig. 3).

3. Dispositif selon la revendication 1,
**caractérisé en ce**
que la sortie du premier intégrateur (93, 94) est raccordée à l'entrée d'un troisième modulateur d'impulsions en largeur (126), qui fonctionne avec une quatrième fréquence, qui fournit les impulsions de sortie pour le second commutateur (104) et pour le registre à décalage (127) (fig. 4).

4. Dispositif selon la revendication 1, 2 ou 3,
**caractérisé en ce**
que le premier commutateur (43) est un commutateur inverseur par l'intermédiaire duquel la seconde grandeur d'entrée (Y) est amenée en alternance à l'entrée du premier intégrateur (16, 17) ou à l'entrée du second intégrateur (46, 47), et que le second commutateur (55) est un commutateur inverseur par lequel un premier ou un second courant de réglage, de préférence égal en étant opposé, est amené en alternance au second intégrateur (46, 47), et qu'un montage en série d'une première et d'une seconde ou d'une troisième et d'une quatrième résistance régulatrice de tension (62, 63, 64, 65) est raccordé respectivement entre les entrées et les sorties du premier et du second intégrateur, le point de prsie (N) entre la première et la seconde résistance (62, 63) étant relié à l'entrée et/ou le point de prise (M) entre la troisième et la quatrième résistance (65, 66) étant relié à la sortie d'un amplificateur (64) de telle manière que la symétrie du dispositif est stabilisée.

5. Dispositif selon la revendication 4,
**caractérisé en ce**
que des trains d'impulsions de polarité opposée sont extraits (en 78, 79) du premier modulateur d'impulsions en largeur (77), ces trains d'impulsions commandant en alternance, par l'intermédiaire d'un troisième commutateur inverseur (82) actionné par un dispositif d'entraînement (129) selon une cinquième fréquence de cycles, un dispositif d'entraînement (84) pour le premier commutateur inverseur (76) et que les contacts de sortie du second commutateur inverseur (104) sont reliés par un commutateur à directions multiples (91, 92), actionné par le dispositif d'entraînement (129) pour le troisième commutateur inverseur (82), en alternance aux entrées du premier et du second intégrateur (93, 94, 95, 96) (fig. 4).

6. Dispositif selon l'une des revendications précédentes 2 à 5,
**caractérisé en ce**
que la troisième, quatrième et cinquième fréquence de cycles sont fournies en étant couplées rigides en phase par un générateur d'impulsions (128), de préférence commandé par cristal.

7. Dispositif selon l'une des revendications précédentes,
**caractérisé en ce**
que la quatrième fréquence de cycles est de l'ordre de dix fois la fréquence de mesure et est, par exemple pour une fréquence de réseau de 50 Hz 300 à 2000, de préférence de 1000 Hz.

8. Dispositif selon l'une des revendications précédentes,
**caractérisé en ce**
que la troisième fréquence de cycles pour le registre à décalage se situe dans la gamme de 30 kHz à 4 MHz.

9. Dispositif selon l'une des revendications précédentes,
**caractérisé en ce**
que la cinquième fréquence de cycles pour le dispositif d'entraînement pour le troisième commutateur inverseur (82) est d'approximativement 1 à 6, par exemple de 4 Hz.
